# EUROPEAN PATENT APPLICATION

(11) **EP 4 518 089 A1**
(43) Date of publication of application: **05.03.2025**
(21) Application number: 23891742.1
(22) Date of filing: 10.07.2023
(51) Int. Cl.: H02J 7/00, G01R 19/165, H01M 10/44

(54) **BATTERY CHARGING CONTROL APPARATUS AND METHOD, AND BATTERY SYSTEM COMPRISING SAME**

(30) Priority: 15.11.2022 KR 20220152598
(71) Applicant: LG Energy Solution, Ltd., Seoul 07335 (KR)
(72) Inventor: KIM, Taesoo, Daejeon 34122 (KR)
(74) Representative: Plasseraud IP
(86) International application number: PCT/KR2023/009736
(87) International publication number: WO 2024/106668

(57) **Abstract**

According to embodiments of the present invention, a battery charging control apparatus and method, and a battery system including the same may charge the battery with a predefined charging current magnitude belonging to a corresponding section based on the state of charge (SOC) of the battery to be charged, charge the battery by adjusting the charging current downwards to magnitude of the charging current of the next section when the battery voltage exceeds a predefined threshold value during charging, determine the magnitude of the charging current for each section based on real-time voltage information, not the state of charge (SOC) information of the battery, and charge the battery with the determined charging current until the battery is fully charged, and thus, lithium precipitation and battery deterioration due to quick charging can be prevented and charging time can be shortened.

## Description

### [Technical Field]

This application claims priority to and the benefit of Korean Patent Application No.10-2022-0152598 filed in the Korean Intellectual Property Office on November 15, 2022, the entire contents of which are incorporated herein by reference.

The present invention relates to an apparatus and method for controlling charge of a battery and a battery system including the same, and more particularly, to an apparatus and method for controlling charge of a battery and a battery system including the same for controlling the magnitude of charging current for charge of a battery and a battery system including the same for charging a battery based on the state of charge information and the voltage value of the battery.

### [Background Art]

As the price of energy sources rises due to depletion of fossil fuels and interest in environmental pollution increases, a demand for secondary batteries as an eco-friendly alternative energy source is rapidly increasing.

Due to the fact that secondary batteries can be repeatedly charged and regenerated, the secondary batteries are being applied to large industrial fields such as automobiles, robots, and energy storage devices, as well as small devices such as mobile phones and laptops as a response to today's environmental regulations and high oil price issues.

Among secondary batteries, lithium secondary batteries are attracting attention due to their advantages such as little memory effect, low self-discharge rate, and high energy density compared to nickel-based secondary batteries.

As the frequency of use of lithium batteries increases, fast/quick charging technology has been introduced to rapidly charge the battery.

Conventional quick charging technology uses a way of quick charging map to obtain information on a size of charging current for quick charging based on the temperature and the state of charge (SOC) of the battery to be charged, thereby rapidly charging the battery.

However, since the conventional quick charging map does not consider voltage state of the battery to be charged, which leads to a disadvantage in that the battery deteriorates and efficiency decreases.

### [Detailed Description of the Invention]

### [Technical Problem]

To obviate one or more problems of the related art, embodiments of the present disclosure provide an apparatus for controlling charge of a battery.

To obviate one or more problems of the related art, embodiments of the present disclosure also provide a method for controlling charge of a battery.

To obviate one or more problems of the related art, embodiments of the present disclosure also provide a battery charging system.

### [Technical Solution]

In order to achieve the objective of the present disclosure, an apparatus for controlling charge of a battery may include a memory and a processor executing at least one instruction in the memory, and the at least one instruction may include an instruction to monitor state of charge (SOC) of the battery to be charged; an instruction to charge the battery according to a predefined charging current value based on the state of charge (SOC) of the battery; an instruction to determine the charging current value based on a voltage value of the battery regardless of the state of charge in the instance that the voltage value of the battery reaches a preset threshold value during the charge process of the battery; and an instruction to charge the battery according to the determined charging current value.

Here, the instruction to charge the battery according to a predefined charging current value may include an instruction to check a N-th section to which the SOC of the battery belongs and an instruction to charge the battery with a charging current value stored corresponding to the N-th section.

Here, the charging current value corresponding to the N-th section may be defined as a value smaller than a charging current value corresponding to the (N-1)-th section.

In the meantime, the instruction to determine the charging current value may include an instruction to monitor whether the voltage value of the battery reaches a voltage threshold value stored corresponding to the N-th section.

Here, the instruction to determine the charging current value may include an instruction to determine the charging current value stored corresponding to the (N+1)-th section as the charging current value for charging the battery in the instance that the voltage value of the battery reaches the voltage threshold value corresponding to the N-th section.

Here, the voltage threshold value corresponding to the N-th section may be defined as a value greater than the voltage threshold value corresponding to the (N-1)-th section.

Meanwhile, the at least one instruction may further include an instruction to control to terminate the charge process of the battery when the battery voltage value reaches the voltage threshold value of the last section.

In order to achieve the objective of the present disclosure, a method for controlling charging of a battery may include monitoring state of charge (SOC) of the battery to be charged; charging the battery according to a predefined charging current value based on the state of charge (SOC) of the battery; determining the charging current value based on a voltage value of the battery in the instance that the voltage value of the battery reaches a preset threshold value during the charge process of the battery; and charging the battery according to the determined charging current value.

The charging the battery according to a predefined charging current value may include checking a N-th section to which the SOC of the battery belongs; and charging the battery with a charging current value stored corresponding to the N-th section.

The charging current value corresponding to the N-th section may be defined as a value smaller than a charging current value corresponding to the (N-1)-th section.

The determining the charging current value may include monitoring whether the voltage value of the battery reaches a voltage threshold value stored corresponding to the N-th section.

The determining the charging current value may include determining the charging current value stored corresponding to the (N+1)-th section as the charging current value for charging the battery in the instance that the voltage value of the battery reaches the voltage threshold value corresponding to the N-th section.

The voltage threshold value corresponding to the N-th section may be defined as a value greater than the voltage threshold value corresponding to the (N-1)-th section.

The method may further include controlling to terminate the charge process of the battery when the battery voltage value reaches the voltage threshold value of the last section.

In order to achieve the objective of the present disclosure, a battery charging system for controlling battery charging may include a battery; a charging device for charging the battery by applying a charging current to the battery; and a battery charging control apparatus that is configured to control a magnitude of the charging current provided by the charging device, wherein the battery charging control apparatus is configured to monitor state of charge (SOC) of the battery to be charged, control the charging device to charge the battery according to a predefined charging current value based on the state of charge (SOC) of the battery, determine the charging current value based on a voltage value of the battery in the instance that the voltage value of the battery reaches a preset threshold value during the charge process of the battery; and control the charging device to charge the battery according to the determined charging current value.

The battery charging control apparatus may further be configured to check a N-th section to which the SOC of the battery belongs and charge the battery with a charging current value stored corresponding to the N-th section.

The charging current value corresponding to the N-th section may be defined as a value smaller than a charging current value corresponding to the (N-1)-th section.

The battery charging control apparatus may further be configured to monitor whether the voltage value of the battery reaches a voltage threshold value stored corresponding to the N-th section.

The battery charging control apparatus may further be configured to determine the charging current value stored corresponding to the (N+1)-th section as the charging current value for charging the battery in the instance that the voltage value of the battery reaches the voltage threshold value corresponding to the N-th section.

The voltage threshold value corresponding to the N-th section may be defined as a value greater than the voltage threshold value corresponding to the (N-1)-th section.

The battery charging control apparatus may further be configured to control the charging device to terminate the charging of the battery when the battery voltage value reaches the voltage threshold value of the last section.

### [Advantageous Effects]

According to embodiments of the present invention, a battery charging control apparatus and method according to embodiments of the present invention, and a battery system including the same may charge the battery with a predefined charging current magnitude belonging to a corresponding section based on the state of charge (SOC) of the battery to be charged, charge the battery by adjusting the charging current downwards to magnitude of the charging current of the next section when the battery voltage exceeds a predefined threshold value during charging, determine the magnitude of the charging current for each section based on real-time voltage information, not the state of charge (SOC) information of the battery, and charge the battery with the determined charging current until the battery is fully charged, and thus, lithium precipitation and battery deterioration due to quick charging can be prevented and charging time can be shortened.

### [Brief Description of the Drawings]

FIG. 1 is a block diagram of a battery system to which embodiments of the present invention may be applied.
FIG. 2 is a block diagram of a battery charging system according to embodiments of the present invention.
FIG. 3 is a block diagram of a battery charging control apparatus according to embodiments of the present invention.
FIG. 4 is a flowchart illustrating a battery charging control method performed by a processor in a battery charging control apparatus according to embodiments of the present invention.
FIG. 5 is a table summarizing state information of a battery in a battery charging control method performed by a battery charging control apparatus of according to embodiments of the present invention.
FIG. 6 is a graph for explaining a battery charging control method based on the table of FIG. 5 according to embodiments of the present invention.
FIG. 7 is a graph for explaining a battery charging control method according to a comparative example of the present invention.

- 1000:: battery
- 3000:: charging device
- 5000:: battery charging control apparatus
- 100:: memory
- 200:: processor
- 300:: transceiver
- 400:: input interface
- 500:: output interface
- 600:: storage device
- 700:: bus

### [Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

Terms used in the present application are used only to describe specific embodiments, and are not intended to limit the present invention. A singular form includes a plural form if there is no clearly opposite meaning in the context. In the present application, it should be understood that the term "include" or "have" indicates that a feature, a number, a step, an operation, a component, a part or the combination thereof described in the specification is present, but does not exclude a possibility of presence or addition of one or more other features, numbers, steps, operations, components, parts or combinations thereof, in advance.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

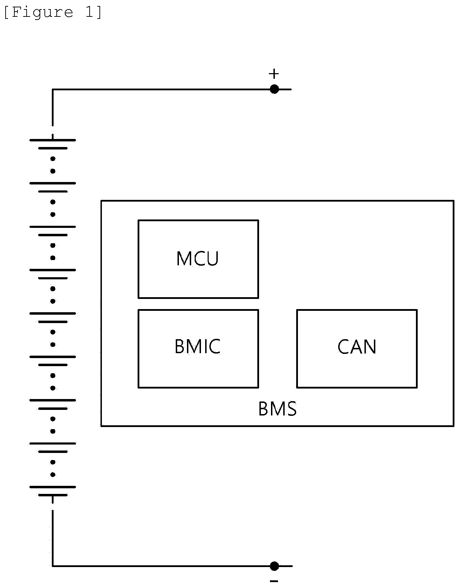

FIG. 1 is a block diagram of a battery system to which embodiments of the present invention may be applied.

Referring to FIG. 1, a battery pack or battery module may include a plurality of battery cells connected in series. The battery pack or module may be connected to a load through a positive terminal and a negative terminal to perform charging or discharging. The most commonly used battery cell is a lithium-ion (Li-Ion) battery cell.

A battery management system (BMS) 100 may be connected to a battery module or battery pack.

The battery management system may monitor a current, a voltage and a temperature of each battery cell or module to be managed, calculate a state of charge (SOC) of the battery based on monitoring results to control charging and discharging. Here, the State of Charge (SOC) refers to a current state of charge of a battery, represented in percent points [%], and the State of Health (SOH) may be a current condition of a battery compared to its ideal conditions, represented in percent points [%].

The BMS may monitor battery cells, read cell voltages, and transmit them to other systems connected to the battery.

Furthermore, the battery management system monitors at least one electrical component constituting the battery system and passes their status data on to other systems. For this, the BMS includes a communication module for communicating with other systems in a device including the battery system.

The communication module of the BMS can communicate with other systems in the device using CAN (Controller Area Network). Here, components, modules or systems in the BMS are connected to each other through a CAN bus. Accordingly, the battery management system (BMS) may use CAN communication to remotely transmit status data obtained through monitoring of the battery pack or module and at least one electrical component constituting the battery management system (BMS) to other systems.

Furthermore, the battery management system (BMS) may equally balance charges of the battery cells in order to extend the life of the battery system.

The BMS 100 may include various components such as a fuse, a current sensing element, a thermistor, a switch, and a balancer to perform such operations. In most cases, a micro controller unit (MCU) or a battery monitoring integrated chip (BMIC) for interworking and controlling these components is additionally included in the BMS.

Meanwhile, a battery charging system according to embodiments of the present invention is provided as a component of a battery management system (BMS) and may control rapid charging of the battery.

Hereinafter, a preferred embodiment of the battery charging system according to the present invention will be described in detail with reference to the attached drawings.

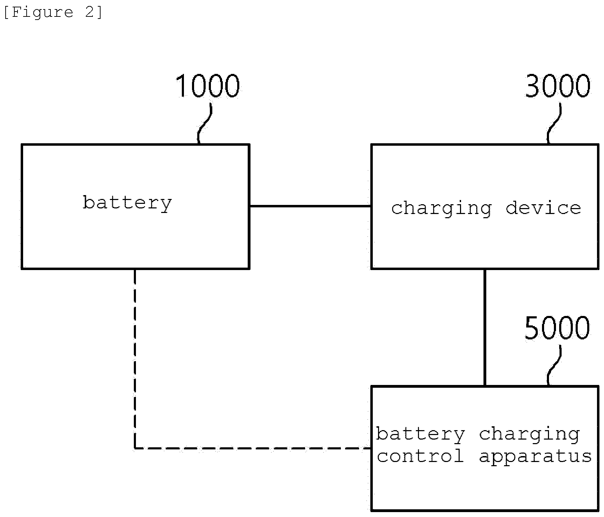

FIG. 2 is a block diagram of a battery charging system according to embodiments of the present invention.

Referring to FIG. 2, a battery charging system according to embodiments of the present invention may be a system that controls fast/quick charging of a battery.

In more detail, the battery charging system may include a battery 1000, a charging device 3000, and a battery charging control apparatus 5000.

The battery 1000 may be provided in a form in which a plurality of battery cells are connected. The battery 1000 is connected to a charging device 3000, which will be described later, and the battery may be charged by a charging current applied from the charging device 3000. Here, the charging current may be adjusted and provided by the battery charging control apparatus 5000, which will be described later, to a level of charging current that avoids lithium precipitation in consideration of the state of charge information of the battery 1000.

The charging device 3000 is electrically connected to the battery 1000 and may charge the battery 1000. To be more specific, the charging device 3000 may be electrically connected to the anode (+) and the cathode (-) of the battery 1000 and charge the battery 1000.

Meanwhile, the charging device 3000 may be connected to the battery charging control apparatus 5000. According to an embodiment, the charging device 3000 may be connected to the battery charging control apparatus 5000 through CAN communication. Accordingly, the charging device 3000 may provide charging current to the battery 1000 according to a charging current value received from the battery charging control apparatus 5000, as described above. In other words, the charging device 3000 may charge the battery 1000 by applying a charging current of a magnitude determined by the battery charging control apparatus 5000 to the battery 1000.

The battery charging control apparatus 5000 may monitor the battery 1000 by receiving at least one piece of state information of the battery 1000. According to embodiments, the state information may include at least one of state of charge (SOC), voltage (V), and current (I) of the battery 1000.

The battery charging control apparatus 5000 may include information on charging current values provided for each section of charging state information of the battery 1000. Accordingly, as described above, the battery charging control apparatus 5000 may be connected to the charging device 3000, check a charging current value in a section to which the charging state information of the battery 1000 belongs, and transmit the charging current value to the charging device 3000.

As the battery charging progresses, the battery charging control apparatus 5000 may adjust the charging current value downward to prevent lithium precipitation. In other words, as the state of charge information increases, the charging current value may decrease. Therefore, the battery charging control apparatus 5000 according to embodiments of the present invention may control the charging current value according to a real-time state of charge information of the battery and provide the charging current of a magnitude adjusted by the charging device 3000 to the battery 1000, thereby preventing lithium precipitation and stably charging the battery.

Meanwhile, the battery charging control apparatus 5000 may include voltage threshold value information of the battery provided for each section of battery charging state information. Here, the voltage threshold value of the battery may be information set to prevent battery deterioration.

According to embodiments, the battery charging control apparatus 5000 may check real-time voltage state of the battery 1000 obtained through monitoring while the battery 1000 is being charged by the charging device 3000. Accordingly, when the voltage value of the battery 1000 reaches a preset voltage threshold value, the battery charging control apparatus 5000 may determine the charging current value of the battery based on the voltage value of the battery, regardless of the state of charge information.

The method of controlling charge current of the battery charging control apparatus 5000 will be described in more detail when the battery charging control method is described later.

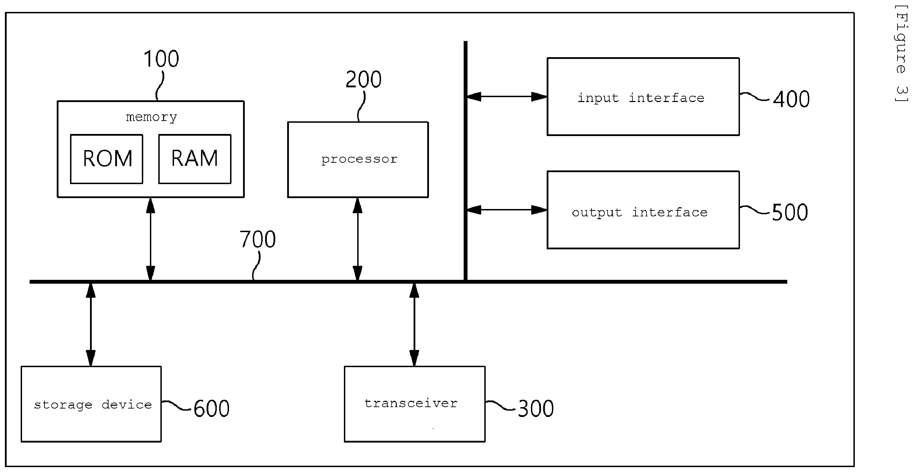

FIG. 3 is a block diagram of a battery charging control apparatus according to embodiments of the present invention.

In more detail as to each component of the battery charging control apparatus 1000 according to embodiments of the present invention referring to FIG. 3, the battery charging control 1000 may include a memory 100, a processor 200, a transceiver 300, an input interface 400, an output interface 500, and a storage device 600.

According to embodiments, respective components 100, 200, 300, 400, 500, 600 included in the battery charging control apparatus 1000 may be connected by a bus 700 to communicate with each other.

The memory 100 and the storage device 600 among the components 100, 200, 300, 400, 500, 600 may include at least one of a volatile storage medium and a non-volatile storage medium. For example, the memory 100 and the storage device 600 may include at least one of read only memory (ROM) and random access memory (RAM).

Among them, the memory 100 may include at least one instruction executed by the processor 200.

According to embodiments, the at least one instruction may include an instruction to monitor state of charge (SOC) of the battery to be charged; an instruction to charge the battery according to a predefined charging current value based on the state of charge (SOC) of the battery; an instruction to determine the charging current value based on a voltage value of the battery regardless of the state of charge in the instance that the voltage value of the battery reaches a preset threshold value during the charge process of the battery; and an instruction to charge the battery according to the determined charging current value.

Here, the instruction to charge the battery according to a predefined charging current value may include an instruction to check a N-th section to which the SOC of the battery belongs and an instruction to charge the battery with a charging current value stored corresponding to the N-th section.

Here, the charging current value corresponding to the N-th section may be defined as a value smaller than a charging current value corresponding to the (N-1)-th section.

In the meantime, the instruction to determine the charging current value may include an instruction to monitor whether the voltage value of the battery reaches a voltage threshold value stored corresponding to the N-th section.

Here, the instruction to determine the charging current value may include an instruction to determine the charging current value stored corresponding to the (N+1)-th section as the charging current value for charging the battery in the instance that the voltage value of the battery reaches the voltage threshold value corresponding to the N-th section.

Here, the voltage threshold value corresponding to the N-th section may be defined as a value greater than the voltage threshold value corresponding to the (N-1)-th section.

The at least one instruction may further include an instruction to control to terminate the charge process of the battery when the battery voltage value reaches the voltage threshold value of the last section.

Meanwhile, the processor 200 may mean a central processing unit (CPU), a graphics processing unit (GPU), or a dedicated processor on which methods according to embodiments of the present invention are performed.

The processor 200 may execute at least one program command stored in the memory 100 as described above.

A battery charging system including a battery charging control apparatus according to embodiments of the present invention has been described above. Hereinafter, a battery charging control method performed by processor operations of the battery charging control apparatus according to embodiments of the present invention will be described in more detail.

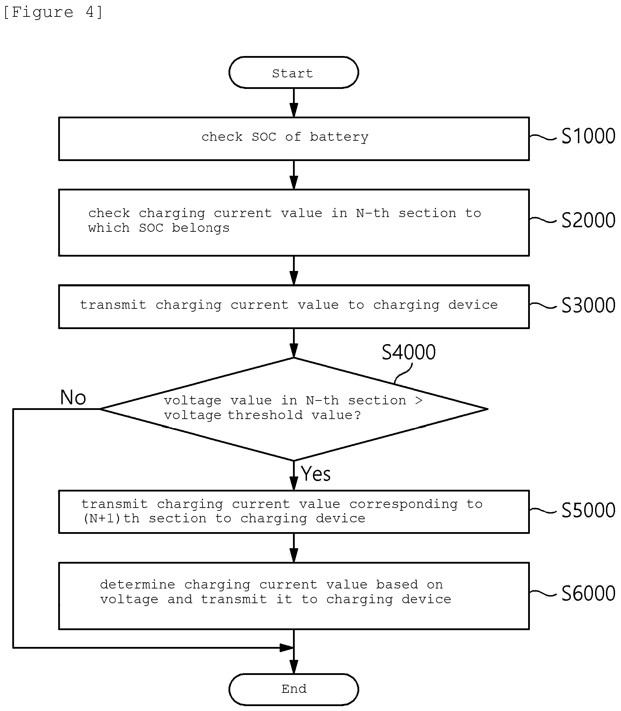

FIG. 4 is a flowchart illustrating a battery charging control method performed by a processor in a battery charging control apparatus according to embodiments of the present invention.

Referring to FIG. 4, the battery charging control apparatus 5000 according to embodiments of the present invention may check the state of charge information of the battery 1000 according to operations of the processor 200 (S1000).

According to an embodiment, the battery charging control apparatus 5000 may monitor the state information of the battery 1000 in real time, obtain and confirm the state of charge information.

According to another embodiment, the battery charging control apparatus 5000 may receive state information of the battery 1000 in real time from a separate monitoring device (not shown). Accordingly, the battery charging control apparatus 5000 may check the state of charge information of the battery 1000 among the state information received from the monitoring device.

Thereafter, the battery charging control apparatus 5000 may check the section to which the state of charge information belongs and check the charging current value corresponding to the section (S2000).

Then, the battery charging control apparatus 5000 may transmit the confirmed charging current value to the charging device 3000 (S3000). Accordingly, the charging device 3000 may charge the battery 1000 by applying a charging current of a magnitude corresponding to the charging current value to the battery 1000.

Thereafter, the battery charging control apparatus 5000 may check voltage values obtained through real-time monitoring of the battery 1000 while charging the battery 1000 according to the charging current value.

According to embodiments, when the voltage value of the battery 1000 reaches a voltage threshold value corresponding to the N-th section, which is a state of charge information section in which a corresponding charging current value is set (S4000), the battery charging control apparatus 5000 may adjust the charging current value. For example, the battery charging control apparatus 5000 may retransmit the charging current value corresponding to the N+1 section of the state of charge information to the charging device 3000 (S5000). Accordingly, the magnitude of the charging current of the charging device 3000 may be changed from the charging current value corresponding to the N-th section to the charging current value corresponding to the (N+1)-th section.

Here, the magnitude of the charging current value may decrease as the state of charge (SOC) increases as described above. Accordingly, when the voltage value of the battery 1000 reaches the voltage threshold value corresponding to the N-th section, which is a state of charge information section in which a corresponding charging current value is set, the battery charging control apparatus 5000 may adjust the magnitude of the charging current for the charging device downward.

Thereafter, the battery charging control apparatus 5000 may determine a charging current value based on the voltage state of the battery without considering changes in the state of charge information of the battery 1000 until charging of the battery 1000 is completed, and transmit the determined charging current value to the charging device 3000 (S6000).

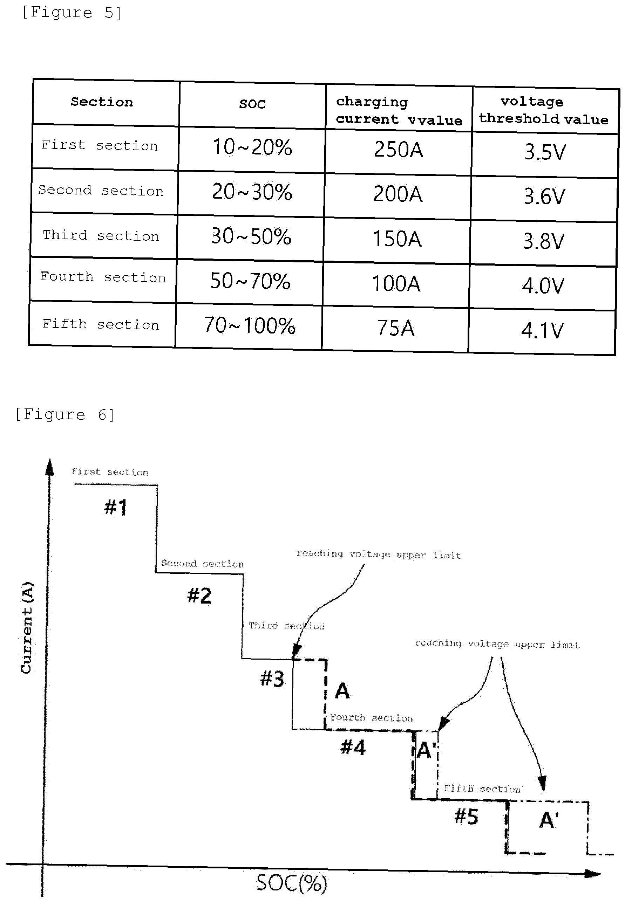

According to embodiments, the battery charging control apparatus 5000 may use the charging current value and voltage threshold value information which are preset for each section based on the state of charge information of the battery when determining the charging current value. For example, the information may be provided in a form of a table type charge map, as shown in FIG. 5 below.

FIG. 5 is a table summarizing state information of a battery in a battery charging control method performed by a battery charging control apparatus of according to embodiments of the present invention and FIG. 6 is a graph for explaining a battery charging control method based on the table of FIG. 5 according to embodiments of the present invention.

Referring to FIG. 5, in the charging map of the battery charging control apparatus according to embodiments of the present invention, a charging current value and a voltage threshold value of the battery may be preset for each section based on the state of charge (SOC).

According to embodiments, in a first section where the state of charge (SOC) is equal to or greater than 10% but less than 20%, the charging current value may be provided as 250A and the corresponding voltage threshold value may be set to 3.5V.

Additionally, in a second section where the state of charge information is equal to or greater than 20% but less than 30%, the value of the charging current may be provided as 200A and the corresponding voltage threshold value may be set to 3.6V.

In a third section, where the state of charge information is equal to or greater than 30% but less than 50%, the charging current value may be provided as 150A and the corresponding voltage threshold value may be set to 3.8V.

In a fourth section, where the state of charge information is equal to or greater than 50% but less than 70%, the value of the charging current may be provided as 100A and the corresponding voltage threshold value may be set to 4.0V.

Lastly, in a fifth section where the state of charge information is equal to or greater than 70% but less than 90%, the value of the charging current may be provided as 75A and the corresponding voltage threshold value may be set to 4.1V.

In summary, the magnitude of the charging current for charging the battery 1000 may be controlled for each section according to the state of charge information and the voltage threshold value.

According to embodiments, the charging current value may be reduced as the section number becomes higher in order to prevent lithium plating that may occur on the negative electrode surface of the battery when rapidly charging the battery, as described above.

Meanwhile, the voltage threshold value may increase as the section number becomes higher to prevent battery degradation.

Accordingly, the battery charging control apparatus 5000 according to embodiments of the present invention, as shown in FIG. 6, may set the charging current value to prevent lithium precipitation in a specific section (N-th section) based on real-time state of charge information of the battery and monitor the real-time voltage measurement value of the battery, and, when the predefined voltage threshold value in the corresponding section (N-th section) is reached, the battery charging control apparatus may adjust the previously set charging current value downward to the charging current value belonging to the next section (N+1 section) so as to prevent battery deterioration.

Thereafter, the battery charging control apparatus 5000 according to embodiments of the present invention may determine the charging current value based on the voltage state of the battery without considering changes in the state of charge information of the battery 1000, as in step S6000 of FIG. 4, and may transmit the determined charging current value to the charging device 3000.

For example, in more detail, when the real-time state of charge information of the battery 1000 is 15% which belongs to the first section (P1), the battery charging control apparatus may determine 250A belonging to the first section as the charging current value and transmit the charging current value to the charging device 3000. Accordingly, the battery 1000 may be charged with the charging current of 250A.

Afterwards, the battery charging control apparatus may monitor status information of the battery 1000 being charged with the charging current of 250A. Here, when the voltage value of the battery 1000 is 3.4V, which is below the voltage threshold value of the first section, whereas the state of charge (SOC) reaches 20% and enters the second section (P2), the battery charging control apparatus 5000 may transmit a signal for changing the charging current value to the charging device 3000 so that the battery 1000 is charged with 200A, which is the charging current value corresponding to the second section. Accordingly, the battery 1000 may be charged with a charging current of 200A.

Afterwards, the battery charging control apparatus may monitor status information of the battery 1000 being charged with the charging current of 200A. Here, when the voltage value of the battery 1000 is 3.5V, which is below the voltage threshold value of the second section, whereas the state of charge (SOC) reaches 30% and enters the third section (P3), the battery charging control apparatus 5000 may transmit a signal for changing the charging current value to the charging device 3000 so that the battery 1000 is charged with 150A, which is the charging current value corresponding to the third section. Accordingly, the battery 1000 may be charged with a charging current of 150A.

Afterwards, the battery charging control apparatus may monitor status information of the battery 1000 being charged with the charging current of 150A. Here, when the voltage value of the battery 1000 reaches 3.8V, which is the voltage threshold value of the third section, whereas the state of charge (SOC) still remains in the third section at 45% (P4), the battery charging control apparatus 5000 may transmit a signal for changing the charging current value to the charging device 3000 so that the battery 1000 is charged with 100A, which is the charging current value corresponding to the fourth section. Accordingly, the battery 1000 may be charged with a charging current of 100A.

Afterwards, the battery charging control apparatus may monitor status information of the battery 1000 being charged with the charging current of 100A. Here, when the voltage value of the battery 1000 is 3.9V, which is still below the voltage threshold value of the fourth section, whereas the state of charge (SOC) increases to 75% which corresponds to the fifth section (P5), the battery charging control apparatus 5000 may maintain the charging current value of 100A which belongs to the fourth section and charge the battery 1000 without any charging current change, despite that the state of charge (SOC) corresponds to the fifth section.

Afterwards, the battery charging control apparatus may monitor status information of the battery 1000 being charged with the charging current of 100A and then, when the voltage value of the battery 1000 reaches 4.0V which belongs to the fifth section (P6), the battery charging control apparatus 5000 may transmit a signal for changing the charging current value to the charging device 3000 regardless of the state of charge information, so that the battery 1000 is charged with 75A, which is the charging current value corresponding to the fifth section. Accordingly, the battery 1000 may be charged with a charging current of 75A.

Afterwards, the battery charging control apparatus may monitor status information of the battery 1000 being charged with the charging current of 75A, and when the voltage value of the battery 1000 reaches 4.1V, which is the voltage threshold value of the fifth section (the last section) (P7), the battery charging control apparatus 5000 may transmit a charging termination signal to the charging device 3000. Accordingly, charging of the battery 1000 may be terminated.

In other words, when the voltage value of the battery does not reach a predefined threshold value for each section, as in the cases of P1 to P3, the battery charging control apparatus 5000 may determine the charging current value step by step by using the state of charge information of the battery 1000.

Meanwhile, when there is no section change as to the charging state information of the battery but the voltage value of the battery reaches a predefined threshold value of the corresponding section, as in the case of P4, the battery charging control apparatus 5000 may change the charging current value based on the voltage value of the battery 1000. In addition, the battery charge control apparatus may determine the charging current value step by step based on the voltage value of the battery 1000, without considering the state of charge information of the battery 1000 as in the cases of P5 and P6 in the subsequent sections, whereas, when the voltage value of the battery 1000 reaches the threshold value of the final section, as in the case of P7, the battery charge control apparatus may transmit a charging termination signal.

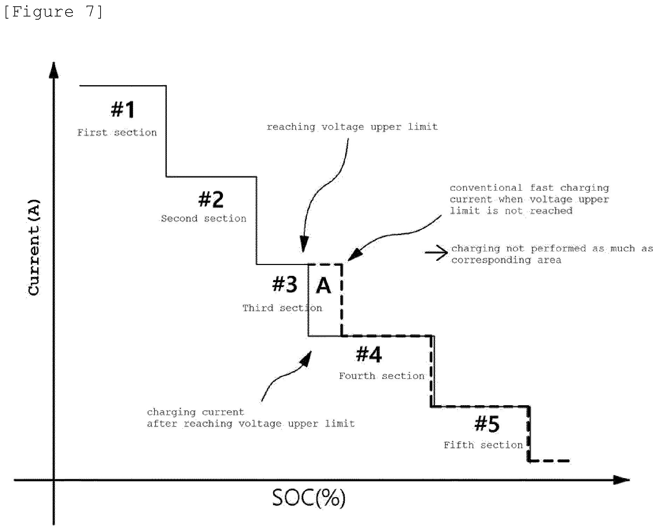

FIG. 7 is a graph for explaining a battery charging control method according to a comparative example of the present invention.

Referring to FIG. 7, a battery charging control apparatus 5000 according to a comparative example controls the charging current of the charging device 3000 by temporarily adjusting the charging current value downward only in a corresponding section (N-th section) to prevent battery deterioration, and thus, the amount of charging current equivalent to area A cannot be applied, thereby increasing charging time and lowering charging efficiency.

On the contrary, the battery charging control apparatus 5000 according to embodiments of the present invention may determine a charging current value for each section based on a voltage value of the battery 1000 after downward adjustment of the charging current, thereby maintaining the charging current value without any reduction until the voltage threshold value predefined for each section is reached. Accordingly, the battery charging control apparatus 5000 according to embodiments of the present invention may compensate for the charge loss equivalent to the area A in the N-th section caused by downward adjustment of the charging current value, in the next SOC sections after the N-th section, such as A', and thus, lithium precipitation and battery deterioration due to rapid charging can be prevented as well as charging time can be shortened.

The battery charging control apparatus and method according to embodiments of the present invention, and a battery system including the same have been described above.

A battery charging control apparatus and method according to embodiments of the present invention, and a battery system including the same may charge the battery with a predefined charging current magnitude belonging to a corresponding section based on the state of charge (SOC) of the battery to be charged, charge the battery by adjusting the charging current downwards to magnitude of the charging current of the next section when the battery voltage exceeds a predefined threshold value during charging, determine the magnitude of the charging current for each section based on real-time voltage information, not the state of charge (SOC) information of the battery, and charge the battery with the determined charging current until the battery is fully charged, and thus, lithium precipitation and battery deterioration due to quick charging can be prevented and charging time can be shortened.

The operations of the method according to the embodiments and experimental examples of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

In addition, the computer-readable recording medium may include hardware devices specially configured to store and execute program instructions, such as ROM, RAM, flash memory, etc. The program instructions may include not only machine language code created by a compiler, but also high-level language code that can be executed by a computer using an interpreter.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range without departing from the spirit and the area of the present invention described in the appending claims.

## Claims

1. An apparatus for controlling charging of a battery, the apparatus comprising:
a memory; and
a processor executing at least one instruction in the memory,
wherein the at least one instruction comprises:
monitoring an SOC of the battery;
charging the battery according to a predefined charging current value based on the SOC of the battery;
in response to a voltage value of the battery reaching a threshold value while charging the battery according to the charging current value, determining the charging current value based on a voltage value of the battery, the charging current value being determined independent of the SOC of the battery; and
charging the battery according to the determined charging current value.

2. The apparatus of claim 1, wherein charging the battery according to a predefined charging current value further comprises:
checking a N-th section of SOCs to which the SOC of the battery belongs; and
charging the battery with a charging current value stored corresponding to the N-th section.

3. The apparatus of claim 2, wherein the charging current value corresponding to the N-th section is defined as a value smaller than a charging current value corresponding to a (N-1)-th section.

4. The apparatus of claim 2, wherein determining the charging current value further comprises monitoring whether the voltage value of the battery reaches a voltage threshold value stored corresponding to the N-th section.

5. The apparatus of claim 4, wherein determining the charging current value further comprises, in response to the voltage value of the battery reaching the voltage threshold value corresponding to the N-th section, determining a charging current value stored corresponding to a (N+1)-th section as the charging current value.

6. The apparatus of claim 5, wherein the voltage threshold value corresponding to the N-th section is defined as a value greater than a voltage threshold value corresponding to the (N-1)-th section.

7. The apparatus of claim 1, wherein the at least one instruction further comprises:
in response to the voltage value of the battery reaching a voltage threshold value corresponding to a last section, terminating charging the battery.

8. A method for controlling charging of a battery, the method comprising:
monitoring an SOC of the battery;
charging the battery according to a predefined charging current value based on the SOC of the battery;
in response to a voltage value of the battery reaching a threshold value while charging the battery according to the charging current value, determining the charging current value based on the voltage value of the battery, the charging current value being determined independent of the SOC of the battery; and
charging the battery according to the determined charging current value.

9. The method of claim 8, wherein charging the battery according to a predefined charging current value further comprises:
checking a N-th section of SOCs to which the SOC of the battery belongs; and
charging the battery with a charging current value stored corresponding to the N-th section.

10. The method of claim 9, wherein the charging current value corresponding to the N-th section is defined as a value smaller than a charging current value corresponding to a (N-1)-th section.

11. The method of claim 9, wherein determining the charging current value further comprises monitoring whether the voltage value of the battery reaches a voltage threshold value stored corresponding to the N-th section.

12. The method of claim 11, wherein determining the charging current value further comprises, in response to the voltage value of the battery reaching the voltage threshold value corresponding to the N-th section, determining a charging current value stored corresponding to a (N+1)-th section as the charging current value.

13. The method of claim 12, wherein the voltage threshold value corresponding to the N-th section is defined as a value greater than a voltage threshold value corresponding to the (N-1)-th section.

14. The method of claim 8, further comprising, in response to the voltage value of the battery reaching a voltage threshold value corresponding to a last section, terminating charging the battery.

15. A battery charging system comprising:
a battery;
a charging device for charging the battery by applying a charging current to the battery; and
a battery charging control apparatus that is configured to control a magnitude of the charging current provided by the charging device, wherein the battery charging control apparatus is configured to:
monitor an SOC of the battery;
control the charging device to charge the battery according to a predefined charging current value based on the SOC of the battery;
in response to a voltage value of the battery reaching a threshold value while charging the battery according to the charging current value, determine the charging current value based on the voltage value of the battery, the charging current value being determined independent of the SOC of the battery; and
control the charging device to charge the battery according to the determined charging current value.

16. The battery charging system of claim 15, wherein the battery charging control apparatus is further configured to:
check a N-th section of SOCs to which the SOC of the battery belongs; and
charge the battery with a charging current value stored corresponding to the N-th section.

17. The battery charging system of claim 16, wherein the charging current value corresponding to the N-th section is defined as a value smaller than a charging current value corresponding to a (N-1)-th section.

18. The battery charging system of claim 16, wherein the battery charging control apparatus is further configured to monitor whether the voltage value of the battery reaches a voltage threshold value stored corresponding to the N-th section.

19. The battery charging system of claim 18, wherein the battery charging control apparatus is further configured to, in response to the voltage value of the battery reaching the voltage threshold value corresponding to the N-th section, determine the charging current value stored corresponding to a (N+1)-th section as the charging current value.

20. The battery charging system of claim 19, wherein the voltage threshold value corresponding to the N-th section is defined as a value greater than a voltage threshold value corresponding to the (N-1)-th section.

21. The battery charging system of claim 15, wherein the battery charging control apparatus is further configured to, in response to the voltage value of the battery reaching a voltage threshold value corresponding to a last section, control the charging device to terminate the charging of the battery.
